# EUROPÄISCHE PATENTSCHRIFT

(11) **EP 0 919 041 B1**
(45) Veröffentlichungstag und Bekanntmachung des Hinweises auf die Patenterteilung: **28.11.2001**
(21) Anmeldenummer: 97942853.9
(22) Anmeldetag: 12.08.1997
(51) Int. Cl.: G06K 19/077

(54) **VERFAHREN ZUR HERSTELLUNG EINES CHIPKARTEN-MODULS FÜR EINE KOMBI-CHIPKARTE**
PROCESS FOR MANUFACTURING A CHIP CARD MODULE FOR A COMBINED CHIP CARD
PROCEDE DE FABRICATION D'UN MODULE DE CARTE A PUCE POUR CARTE A PUCE COMBINEE

(30) Priorität: 14.08.1996 DE 19632813
(43) Veröffentlichungstag der Anmeldung: 02.06.1999
(73) Patentinhaber: Infineon Technologies AG, 81669 München (DE); PAV Card GmbH, 22952 Lütjensee (DE)
(72) Erfinder: HOUDEAU, Detlef, D-84085 Langquaid (DE); WILM, Robert, D-22946 Kasseburg (DE)
(74) Vertreter: Hermann, Uwe, Dipl.-Ing.
(86) Internationale Anmeldenummer: EP9704378
(87) Internationale Veröffentlichungsnummer: WO9807115

(56) Entgegenhaltungen:
- EP-A- 0 671 705
- DE-A- 3 924 439
- DE-A- 19 500 925
- US-A- 5 027 190

## Beschreibung

Die Erfindung betrifft ein Verfahren zur Herstellung eines Chipkarten-Moduls für eine Kombi-Chipkarte.

Unter Kombi-Chipkarte (oder kurz Kombikarte) soll im folgenden eine Chipkarte verstanden werden, bei der Daten und Informationen sowohl auf herkömmliche Weise durch Abgreifen galvanischer Kontakte als auch kontaktlos auf induktivem Wege mit einem Kartenlese-/-schreibgerät ausgetauscht werden können.
Derartige Kombikarten können beispielsweise als Kleingeldbörse oder zur Personenzugangskontrolle mit Registrierung verwendet werden.

Für die herkömmliche, sogenannte kontaktbehaftete, Datenübertragung weisen Chipkarten an einer ihrer Oberflächen Kontaktflächen auf, die üblicherweise den ISO-Standards 7810 oder 7816 entsprechen, und die mittels elektrischen Abhebekontaktes abgelesen werden. Die Kontaktflächen für die kontaktbehaftete Datenübertragung werden im folgenden allgemein als erste Kontaktebene oder vereinfacht als ISO-Kontaktflächen bezeichnet. Ein Chipmodul für eine solche herkömmliche Chipkarte ist beispielsweise in der DE-A-39 24 439 beschrieben.

Für die Datenübertragung auf induktivem Wege ist in die Chipkarte eine Antenne integriert. Üblicherweise wird eine elektrische Spule in von außen nicht sichtbarer Weise in dem Chipkartenkörper angeordnet. Geeignet sind beispielsweise Spulen mit einer Trägerfrequenz in einem offenen Industrieband, z.B. 13,56 MHz.

Die Erfindung wird nachfolgend am Beispiel einer elektrischen Spule beschrieben, ohne auf diese spezielle Ausgestaltung einer Antenne beschränkt zu sein. Der nach dem erfindungsgemäßen Verfahren hergestellte Chipkarten-(CC-)Modul eignet sich darüber hinaus grundsätzlich auch zur Kontaktierung anderer zu kontaktierender Elemente einer Chipkarte.

Sollen in einer Chipkarte beide oben beschriebenen Datenübertragungssysteme kombiniert werden, ist es notwendig, vom Halbleiterchip elektrisch leitende Verbindungen sowohl zu den ISO-Kontakten als auch zur Spule zu schaffen.

Die Herstellung der ISO-Kontakte erfolgt in der Regel derart, daß zunächst ein Chipkarten-Modul hergestellt wird, der dann in eine Ausnehmung im Kartenträger eingesetzt (implantiert) wird. Der Chipkarten-Modul besteht aus einem flexiblen Trägermaterial, beispielsweise einer glasfaserverstärkten Epoxidfolie, auf deren einer Seite der Halbleiterchip angeordnet ist und auf der anderen Seite die ISO-Kontaktflächen. Letztere bestehen im allgemeinen aus einer Kupferschicht mit einer Oberflächenveredelung aus einer Nickelschicht und einer Goldschicht. Die ISO-Kontaktflächen und der Halbleiterchip sind durch Ausnehmungen in der Modul-Trägerfolie mit Bonddrähten leitend verbunden.

Theoretisch wäre es denkbar, die weiteren für die elektrische Kontaktierung der Spule benötigten Anschlüsse auf die ISO-Kontaktflächen zu legen, die ISO-Kontaktflächen also um zwei zusätzliche Felder zu erweitern.
Eine derartige Anordnung hätte jedoch den Nachteil, daß die Anschlußstellen an der Oberfläche der Chipkarte zu liegen kämen und dadurch Störeinflüssen und Manipulationen zugänglich wären. Durch Berührung der Kontaktflächen und/oder physikalische Kontakte mit metallischen Gegenständen und dadurch ausgelöste Kurzschlüsse kann es beispielsweise zu Verschiebungen der Eigenfrequenz kommen. Betriebsstörungen oder völlige Funktionsausfälle wären die Folge. Um derartige Störungen und Manipulationen der induktiv zu übertragenden Information auszuschließen, mußten also andere Wege der Kontaktierung zwischen Halbleiterchip und Spule gefunden werden.

In der DE-A-195 00 925 wird eine Cjipkarte zur sowohl kontaktlosen als auch kontaktbehafteten Datenübertragung beschrieben, bei der der in den Kartenkörper eingebaute Chip-Modul zwei einander gegenüberliegende Anschlußebenen für den kontaktbehafteten Datenaustausch bzw. für den Anschluß einer Antenne aufweist.
Darüber hinaus werden in DE-A-195 oo 925 Verfahren beschrieben, wie ein solcher Chip-Modul in den Kartenkörper eingebaut und die notwendigen Kontaktierungen durchgeführt werden können.

Die bisher eingesetzten Verfahren zur Herstellung von Chipkarten.Modulen beinhalten zahlreiche Verfahrensschritte wie z.B. das getrennte Strukturieren einer oder mehrerer Anschlußebenen (z.B. durch Ätzen) bzw. des Modulträgerbands (durch Stanzen oder Bohren) und sind daher zeitaufwendig und teuer.

**Aufgabe** der Erfindung war es daher, ein Verfahren zur Herstellung eines CC-Moduls für eine Kombi-Chipkarte zu schaffen, das es erlaubt, eine Antenne (Induktionsspule) oder sonstige zu kontaktierende Bestandteile einer Chipkarte auf einfache und kostengünstige Weise anzuschließen, wobei bei dem nach diesem Verfahren hergestellten CC-Modul der Einfluß von Störungen oder Manipulationen auf die Anschlüsse weitgehend ausgeschlossen sein soll.

Die Lösung dieser Aufgabe gelingt mit dem Verfahren zur Herstellung eines CC-Moduls gemäß Anspruch 1.

Demgemäß betrifft die Erfindung ein Verfahren zur Herstellung eines CC-Moduls, der einen Träger und auf diesem angeordnet eine erste Kontaktebene (ISO-Kontaktflächen) und einen Halbleiterchip umfaßt. Der CC-Modul kann auf herkömmliche Weise aufgebaut sein. Beispielsweise kann es sich bei dem Träger um eine Kunststoff-Folie, insbesondere eine glasfaserverstärkte Epoxidfolie, handeln, die Ausnehmungen für den Halbleiterchip und für die Bonddrähte aufweist, mit denen der Halbleiterchip mit der ersten Kontaktebene (ISO-Kontaktflächen) verbunden wird. Die ISO-Kontaktflächen können aus einer Kupferschicht bestehen, die mit Schichten aus Nickel und Gold überzogen ist. Die Kontaktflächen entsprechen üblicherweise den Standards ISO 7810 oder 7816.

Der nach dem erfindungsgemäßen Verfahren hergestellte CC-Modul weist eine weitere Anschlußebene auf, die auf der der ersten Kontaktebene gegenüberliegenden Seite des Modulträgers angeordnet ist. Die zusätzliche Anschlußebene liegt also in der Regel auf derselben Seite des Trägers wie der Halbleiterchip. Die weitere Anschlußebene besteht zweckmäßig aus Metall. Um ihr dieselbe Bondfähigkeit zu verleihen wie die erste Kontaktebene, ist sie bevorzugt genauso aufgebaut wie diese. Beispielsweise besteht sie also aus einer Kupferschicht, die mit Schichten aus Nickel und Gold überzogen ist.

Die weitere Anschlußebene ist strukturiert, um die benötigte Zahl von Anschlußstellen zur Induktionsspule oder sonstigen zu kontaktierenden Bestandteilen einer Chipkarte zu schaffen.

Bevorzugt erfolgt die Strukturierung der weiteren Anschlußebene durch Stanzen oder ähnliches. Sie erfolgt nach dem erfindungsgemäßen Verfahren gleichzeitig mit dem Stanzen der Ausnehmung für den Halbleiterchip, der Durchbrüche für die Bonddrähte und gegebenenfalls der Transportöffnungen in den Modulträger. Auf diese Weise läßt sich die Herstellung der weiteren Anschlußebene stark vereinfachen.

Die weitere Anschlußebene oder zumindest deren Basisschicht wird also noch vor der Strukturierung des Modulträgers auf diesen aufgebracht. Besteht die weitere Anschlußebene aus einer Schichtfolge Cu-Ni-Au, wird beispielsweise zunächst ein Kupferstreifen auf eine Seite des Modulträgers, vorzugsweise mittig, auflaminiert. Danach erfolgt die Strukturierung des Modulträgers durch Stanzen oder ähnliches. Anschließend werden die Nickel- und Goldschicht aufgalvanisiert. Besonders bevorzugt wird die Galvanisierung gleichzeitig mit der galvanischen Beschichtung der ISO-Kontaktflächen (der ersten Kontaktebene) durchgeführt, die sich auf der anderen Seite des Modulträgers befinden. Anschließend wird der Halbleiterchip auf an sich bekannte Weise auf dem CC-Modul befestigt. Dann werden die elektrisch leitenden Verbindungen zu der ersten Anschlußebene (den ISO-Kontaktflächen) und den zusätzlichen Anschlußstellen der weiteren Anschlußebene auf übliche Weise hergestellt, z.B. unter Verwendung von Bonddrähten aus Gold.

Falls gewünscht, kann zum Schutz des Halbleiterchips auf dem CC-Modul ein den Halbleiterchip umgebender Stützring angebracht werden. Zweckmäßig dient dieser Stützring gleichzeitig als laterale Begrenzung für die den Chip abdeckende Kunststoffmasse. Bevorzugt besteht der Stützring aus einem federelastischen Material, z.B. aus Metall und insbesondere aus Kupfer. Um Kurzschlüsse zwischen dem Stützring und der weiteren Anschlußebene zu vermeiden, wird zwischen beiden zweckmäßig ein Dielektrikum angeordnet. Das Dielektrikum kann beispielsweise der Klebstoff sein, mit dem der Stützring am Modul befestigt wird. Vorzugsweise wird ein druckempfindlicher Klebstoff verwendet.

Der nach dem erfindungsgemäßen Verfahren hergestellte CC-Modul (mit oder ohne Stützring) kann auf an sich bekannte Weise unter Verwendung herkömmlicher Verfahren in den Kartenkörper der Chipkarte implantiert werden. Beispielsweise wird in den Kartenkörper, üblicherweise eine Kunststoff-Folie, z.B. aus Polycarbonat, eine Kavität gefräst, deren Form und Größe dem zu implantierenden CC-Modul entspricht. Der CC-Modul wird in diese Kavität üblicherweise unter Verwendung eines Heiß- oder Schmelz-Klebstoffs eingeklebt (sogenanntes Hotmelt-Verfahren).

Besonders bevorzugt ist es, wenn die Antenne (Induktionsspule), die mit der zusätzlichen Anschlußebene des CC-Moduls verbunden werden soll, im Kartenträger integriert oder auf diesem angeordnet ist. Ist die Induktionsspule eine Spule aus Kupferdraht, der von außen nicht sichtbar in den Kartenkörper eingelassen ist, werden die Anschlußstellen vor dem Implantieren des CC-Moduls beispielsweise durch Fräsen der Kartenkörperoberfläche freigelegt. Besonders bevorzugt erfolgt die Freilegung der Anschlußstellen gleichzeitig mit dem Fräsen der Kavität für den CC-Modul.

Die elektrisch leitenden Verbindungen zwischen der weiteren Anschlußebene des CC-Moduls und den Anschlüssen der Induktionsspule werden entweder durch Aufbringen von Weichlot oder mit Hilfe eines anisotrop leitenden Klebstoffs hergestellt.

Die Erfindung soll im folgenden unter Bezugnahme auf eine Zeichnung näher erläutert werden. Dabei zeigen
- Fig. 1: schematisch einen Querschnitt durch einen nach dem erfindungsgemäßen Verfahren hergestellten CC-Modul;
- Fig. 2: schematisch einen Kartenkörper zur Aufnahme des nach dem erfindungsgemäßen Verfahren hergestellten CC-Moduls in Draufsicht und
- Fig. 3: schematisch einen Querschnitt durch den Kartenkörper gemäß Fig. 2 entlang der Linie A-A.

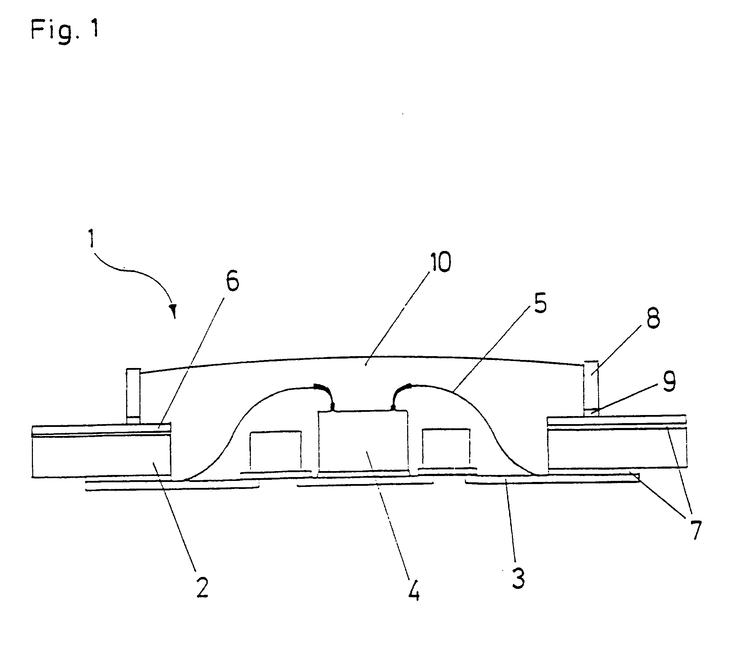

Im einzelnen zeigt Fig. 1 ein Beispiel eines nach dem erfindungsgemäßen Verfahren hergestellten CC-Moduls 1 mit einem Modulträger 2, der beispielsweise aus einer Kunststoffolie wie glasfaserverstärkter Epoxidfolie bestehen kann. Auf der unteren Seite des Trägers 2 ist eine erste Kontaktebene 3 mittels eines Klebstoffs 7 auflaminiert. Die erste Kontaktebene besteht üblicherweise aus Kontaktflächen, die den ISO-Standards 7810 oder 7816 entsprechen. Die Kontaktflächen selbst können beispielsweise aus einer mit Schichten aus Nikkel und Gold überzogenen Kupferfolie bestehen.

Auf der der ersten Kontaktebene 3 gegenüberliegenden Seite des Trägers 2 ist eine weitere Anschlußebene 6 angeordnet, die beispielsweise aus Metall und insbesondere aus einer mit Klebstoff 7 auflaminierten nickel- und goldbeschichteten Kupferfolie besteht. Die weitere Anschlußebene umfaßt eine rechte und eine linke Anschlußstelle.

In einer Ausnehmung des Trägers 2 ist ein Halbleiterchip 4 angeordnet, der mit der ersten Kontaktebene 3 und der weiteren Anschlußebene 6 elektrisch leitend verbunden ist. Im vorliegenden Fall sind nur die Verbindungen 5 zur ersten Kontaktebene 3 gezeigt, die mit Bonddrähten, zum Beispiel aus Gold, hergestellt und durch weitere Durchbrüche im Träger 2 geführt sind. Die nicht gezeigten Verbindungen von Halbleiterchip und weiterer Anschlußebene 6 (d.h. rechter und linker Anschlußstelle) können auf gleiche Weise wie zur ersten Kontaktebene 3 erzielt werden, also beispielsweise ebenfalls mit Bonddrähten.

Zum Schutz des Halbleiterchips 4 ist auf der weiteren Anschlußebene 6 ein Stützring 8 angebracht, der den Halbleiterchip umschließt. Der Stützring 8 besteht zweckmäßig aus einem federelastischen Material und insbesondere aus Metall, beispielsweise aus Kupfer. Um Kurzschlüsse zwischen den Anschlußstellen der weiteren Anschlußebene 6 und dem Stützring 8 zu verhindern, ist zwischen weiterer Anschlußebene und Stützring ein Dielektrikum 9 eingefügt. Bevorzugt wird der Stützring 8 aufgeklebt. Dabei dient der Klebstoff zweckmäßig als Dielektrikum. Besonders bevorzugt wird ein druckempfindlicher Klebstoff verwendet.

Der Stützring 8 kann gleichzeitig auch als laterale Begrenzung für die Kunststoffmasse 10, zum Beispiel Silikonlack oder Epoxidharz, dienen, mit der der Halbleiterchip 4 abgedeckt ist.

Der CC-Modul 1 wird mit Hilfe des erfindungsgemäßen Verfahrens hergestellt, das die folgenden Schritte umfaßt:
- Auflaminieren eines Metallstreifens in Längsrichtung auf eine erste Seite eines Modulträgerbands als weitere Anschlußebene (6),
- Strukturieren des Metallstreifens zu einzelnen Anschlußstellen der weiteren Anschlußebene (6),
- Auflaminieren einer Metallfolie auf die andere Seite des Modulträgerbandes und Strukturieren der ersten Kontaktebene (3),
- Strukturieren des Modulträgerbandes durch Einbringen von Durchbrüchen für den Halbleiterchip (4) und/oder für elektrisch leitfähige Verbindungen (5),
- gegebenenfalls galvanisches Beschichten der ersten Kontaktebene (3) und/oder der weiteren Anschlußebene (6),
- gegebenenfalls Anbringen eines Stützringes (8) auf der weiteren Anschlußebene (6),
- Montieren der Halbleiterchips (4) und Kontaktieren (5) mit erster Kontaktebene (3) und weiterer Anschlußebene (6),
- Umhüllen der Halbleiterchips (4) mit Kunststoff und
- Vereinzeln der Chipkarten-Module (1).

Die obigen Schritte müssen nicht alle in der angegebenen Reihenfolge durchgeführt werden. Im erfindungsgemäßen Verfahren ist jedoch vorgesehen, daß das Auflaminieren des Metallstreifens für die weitere Anschlußebene und dessen Strukturierung zu einzelnen Anschlußstellen vor dem Auflaminieren und Strukturieren der ersten Kontaktebene erfolgt und das Strukturieren der weiteren Anschlußebene gemeinsam mit dem Strukturieren des Modulträgerbandes erfolgt.

Hier wird also zunächst ein Kupferstreifen, der beispielsweise eine Breite von 200 µm bis 1 mm besitzen kann, im wesentlichen mittig und in Längsrichtung auf das Modulträgerband auflaminiert.

Der Ausdruck "Modulträgerband" bezieht sich in diesem Zusammenhang auf eine Trägerfolie für eine Reihe aufeinanderfolgender Moduleinheiten. Bei im wesentlichen mittiger Anordnung des Metallstreifens befindet sich dieser also auch im fertigen Modul im wesentlichen in dessen Mittelbereich. Diese Definition schließt jedoch auch Trägerfolien größerer Breite ein, auf denen beispielsweise mehrere Reihen von Moduleinheiten parallel zueinander Platz finden. In einem solchen Fall wird pro Modulreihe ein Metallstreifen auflaminiert.
Nach Aufbringen des Metallstreifens wird dieser in einem anschließenden Schritt strukturiert, so daß einzelne Anschlußstellen erhalten werden. Das Strukturieren kann zweckmäßig durch Einstanzen von Trennflächen in das Metallband erfolgen. Die Strukturierung erfolgt gleichzeitig mit der Strukturierung des Modulträgers 2. Durch Einstanzen der Ausnehmungen für den Halbleiterchip 4, der Durchbrüche für die Bonddrähte 5 zur Kontaktierung des Halbleiterchips mit der ersten Kontaktebene und für die Transportöffnungen entstehen in der weiteren Anschlußebene gleichzeitig Trennflächen und damit isolierte Anschlußstellen.

Das Aufbringen der ersten Kontaktebene geschieht auf an sich bekannte Weise und zwar nach dem Auflaminieren der weiteren Anschlußebene, bei einer Metallisierungsschicht Cu-Ni-Au also nach Auflaminieren der Kupferschicht.

Um eine gleiche Bondfähigkeit der ersten und zweiten Kontaktebene zu erreichen, kann die weitere Anschlußebene ebenfalls oberflächenveredelt werden, beispielsweise durch galvanisches Beschichten mit Nickel und Gold. Zweckmäßig erfolgt die galvanische Beschichtung nach der Strukturierung und insbesondere gemeinsam mit der galvanischen Beschichtung der ersten Kontaktebene.
Anschließend kann zum Schutz des Halbleiterchips noch ein Stützring 8 aufgebracht werden, zweckmäßig durch Aufkleben mit einem druckempfindlichen Klebstoff.

Das Umhüllen des Halbleiterchips 4 mit Kunststoff 10 geschieht auf übliche Weise. Der Stützring 8 kann dabei als laterale Begrenzung der Kunststoffmasse dienen.

Der nach dem erfindungsgemäßen Verfahren hergestellte CC-Modul hat den Vorteil, daß er nicht nur unter Verwendung herkömmlicher Verfahrensschritte sondern auch auf übliche Weise in den Kartenkörper implantiert werden kann.

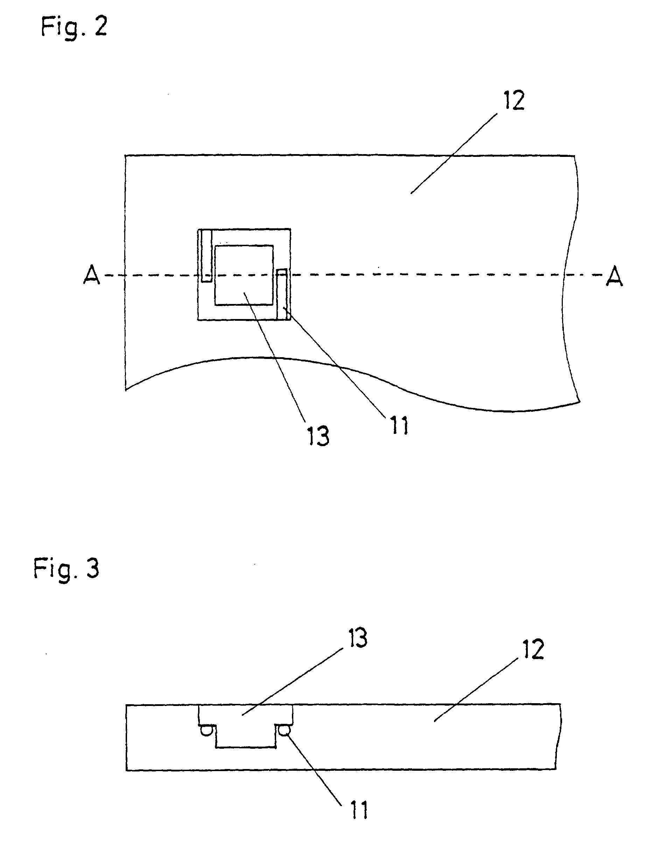

Es wird also auf bekannte Weise eine Kavität im Kartenkörper, üblicherweise einer Kunststoffolie aus Polycarbonat, erzeugt, deren Form und Größe dem zu implantierenden CC-Modul angepaßt ist. Der CC-Modul kann unter Verwendung des weitverbreiteten Hotmelt-Verfahrens implantiert werden. Zur Herstellung der elektrisch leitenden Verbindung zwischen den Anschlußstellen der weiteren Anschlußebene 6 des CC-Moduls 1 und einer in den Kartenkörper integrierten Antenne, beispielsweise einer versenkten Kupferdrahtspule, oder allgemein einem Mittel zur kontaktlosen Datenübertragung, wird so vorgegangen, daß in der Kavität, die den CC-Modul aufnehmen soll, Anschlußstellen freigelegt werden. Besonders bevorzugt werden die Anschlußstellen gleichzeitig mit dem Fräsen der Kavität freigelegt. Zu diesem Zweck kann die Kavität beispielsweise ein treppenförmiges Profil erhalten, wie dies in Figuren 2 und 3 angedeutet ist.

Fig. 2 zeigt einen Kartenkörper 12 mit einer Kavität 13, in der zwei Anschlußstellen der Antenne 11 freigelegt sind. In Fig. 3 ist ein Schnitt entlang der Linie A-A in Fig. 2 abgebildet, worin das treppenförmige Profil der Kavität 13 zu erkennen ist. Beim Implantieren kommt die erste Kontaktebene 3 des CC-Moduls oben zu liegen, und die Anschlußstellen der weiteren Anschlußebene 6 liegen auf den freigefrästen Anschlußstellen der Antenne 11 auf.

Die elektrisch leitende Verbindung in diesem Bereich kommt beispielsweise dadurch zustande, daß im Bereich der Anschlußstellen Weichlot oder ein anisotrop leitender Klebstoff aufgebracht wird. Um im Hotmelt-Verfahren einsetzbar zu sein, besitzt das Weichlot zweckmäßig einen Erweichungspunkt im Bereich von etwa 110°C.

Der nach dem erfindungsgemäßen Verfahren hergestellte CC-Modul weist zusätzlich zu einer ersten Kontaktebene (ISO-Kontaktflächen) eine weitere Anschlußebene auf, die gegen Störungen und Manipulationen von außen gesichert ist. Der CC-Modul kann unter Verwendung gängiger Verfahren in einen Kartenkörper implantiert werden, so daß auch die Herstellung von Chipkarten auf einfache und kostengünstige Weise möglich ist.

## Patentansprüche

1. Verfahren zur Herstellung eines Chipkarten-Moduls (1), welcher einen Träger (2) mit einer ersten Kontaktebene (3) und einem Halbleiterchip (4) sowie elektrisch leitfähigen Verbindungen (5) zwischen Halbleiterchip und erster Kontaktebene umfaßt, und welcher auf der der ersten Kontaktebene (3) gegenüberliegenden Seite des Trägers (2) eine weitere Anschlußebene (6) umfaßt, welche mit dem Halbleiterchip (4) elektrisch leitend verbunden ist,
**dadurch gekennzeichnet,**
**daß** es, unabhängig von deren Reihenfolge, die folgenden Schritte umfaßt:
- Auflaminieren eines Metallstreifens in Längsrichtung auf eine erste Seite eines Modulträgerbands als weitere Anschlußebene (6),
- Strukturieren des Metallstreifens zu einzelnen Anschlußstellen der weiteren Anschlußebene (6),
- Auflaminieren einer Metallfolie auf die andere Seite des Modulträgerbandes und Strukturieren der ersten Kontaktebene (3),
- Strukturieren des Modulträgerbandes durch Einbringen von Durchbrüchen für die Halbleiterchips (4) und/oder für elektrisch leitfähige Verbindungen (5),
- Montieren der Halbleiterchips (4) und Kontaktieren (5) mit erster Kontaktebene (3) und weiterer Anschlußebene (6),
- Umhüllen der Halbleiterchips (4) mit Kunststoff und
- Vereinzeln der Chipkarten Module (1), wobei
- das Auflaminieren des Metallstreifens für die weitere Anschlußebene (6) und dessen Strukturierung zu einzelnen Anschlußstellen vor dem Auflaminieren und Strukturieren der ersten Kontaktebene (3) erfolgt und
- das Strukturieren der weiteren Anschlußebene (6) gemeinsam mit dem Strukturieren des Modulträgerbandes erfolgt.

2. Verfahren gemäß Anspruch 1,
**dadurch gekennzeichnet,**
**daß** es weiter wenigstens einen der folgenden Schritte umfaßt:
- galvanisches Beschichten der ersten Kontaktebene (3) und/oder der weiteren Anschlußebene (6)
- Anbringen eines Stützringes (8) auf der weiteren Anschlußebene (6).

3. Verfahren gemäß Anspruch 1 oder 2,
**dadurch gekennzeichnet, daß**
die weitere Anschlußebene (6) aus Kupfer besteht und das Kupfer mit einer galvanischen Beschichtung aus Nickel, gefolgt von einer galvanischen Beschichtung aus Gold versehen wird.

4. Verfahren gemäß einem der Ansprüche 1 bis 3,
**dadurch gekennzeichnet, daß**
der Metallstreifen im wesentlichen mittig auf eine erste Seite des Modulträgerbandes auflaminiert wird.

5. Verfahren gemäß einem der Ansprüche 1 bis 4,
**dadurch gekennzeichnet, daß**
das galvanische Beschichten von erster Kontaktebene (3) und weiterer Anschlußebene (6) gemeinsam erfolgt.

6. Verfahren gemäß einem der Ansprüche 1 bis 5,
**dadurch gekennzeichnet, daß**
ein Stützring (8) auf der weiteren Anschlußebene (6) insbesondere unter Verwendung eines druckempfindlichen Klebstoffs (9) aufgeklebt wird.

7. Verfahren gemäß einem der Ansprüche 1 bis 6,
**dadurch gekennzeichnet, daß**
die Strukturierung der weiteren Anschlußebene (6) dergestalt vorgenommen wird, daß zwei Anschlußstellen zur Verbindung mit einer Antenne (11), insbesondere einer Induktionsspule, für die induktive Datenübertragung gebildet werden.

8. Verfahren gemäß einem der Ansprüche 1 bis 7,
**dadurch gekennzeichnet, daß**
die erste Kontaktebene (3) als ISO-Kontaktflächen strukturiert wird.

## Claims

1. Method for producing a chip card module (1) which comprises a substrate (2) with a first contact plane (3) and a semiconductor chip (4) as well as electrically conductive connections (5) between the semiconductor chip and first contact plane, and which comprises on the side of the substrate (2) opposite the first contact plane (3) a further connecting plane (6) which is connected in an electrically conducting fashion to the semiconductor chip (4), **characterized in that**, independently of their sequence, it comprises the following steps:
- laminating a metal strip in the longitudinal direction onto a first side of a module substrate ribbon as a further connecting plane (6),
- structuring the metal strip to form individual connecting sites of the further connecting plane (6),
- laminating a metal foil onto the other side of the module substrate ribbon and structuring the first contact plane (3),
- structuring the module substrate ribbon by introducing openings for the semiconductor chip (4) and/or for electrically conductive connections (5),
- mounting the semiconductor chip (4) and making contact (5) with a first contact plane (3) and a further connecting plane (6),
- enclosing the semiconductor chip (4) with plastic, and
- separating the chip card module (1), it being the case that
- laminating on the metal strip for the further connecting plane (6) and structuring it to form individual connecting sites are performed before laminating and structuring the first contact plane (3), and
- structuring the further connecting plane (6) is performed in common with structuring the module substrate ribbon.

2. Method according to Claim 1, **characterized in that** it further comprises at least one of the following steps:
- electroplating the first contact plane (3) and/or the further connecting plane (6), and
- fitting a support ring (8) on the further connecting plane (6).

3. Method according to Claim 1 or 2, **characterized in that** the further connecting plane (6) consists of copper and the copper is provided with an electroplating of nickel followed by an electroplating of gold.

4. Method according to one of Claims 1 to 3,
**characterized in that** the metal strip is laminated essentially in the middle onto a first side of the module substrate ribbon.

5. Method according to one of Claims 1 to 4,
**characterized in that**, electroplating of the first contact plane (3) and the further connecting plane (6) is performed jointly.

6. Method according to one of Claims 1 to 5,
**characterized in that** a support ring (8) is bonded on the further connecting plane (6), in particular using a pressure-sensitive adhesive (9).

7. Method according to one of Claims 1 to 6,
**characterized in that** the structuring of the further connecting plane (6) is carried out in such a way that two connecting sites for connection to an antenna (11), in particular an induction coil, for inductive data transmission are formed.

8. Method according to one of Claims 1 to 7,
**characterized in that** the first contact plane (3) is formed by ISO contact surfaces.

## Revendications

1. Procédé de fabrication d'un module (1) de carte à puce, qui comporte un support (2) ayant un premier plan (3) de contact et une puce (4) à semiconducteur, ainsi que des liaisons (5) conductrices de l'électricité entre la puce à semiconducteur et le premier plan de contact, et qui comprend, du côté du support (2) opposé au premier plan de contact, un autre plan (6) de raccordement, qui est relié d'une manière conductrice de l'électricité à la puce (4) à semiconducteur,
**caractérisé**
**en ce qu'**il comprend quel que soit leur ordre de succession les stades suivants :
- application d'une bande métallique dans la direction longitudinale sur un premier côté d'une bande porte-module, en tant qu'autre plan (6) de raccordement,
- structuration de la bande métallique en des points individuels de raccordement de l'autre plan (6) de raccordement,
- application d'une feuille métallique de l'autre côté de la bande du support de module et structuration du premier plan (3) de contact,
- structuration de la bande porte-module en ménageant des traversées pour les puces (4) à semiconducteur et/ou pour les liaisons (5) conductrices de l'électricité,
- montage des puces (4) à semiconducteur et de contact (5) ayant un premier plan (3) de contact et un autre plan (6) de raccordement,
- enrobage des puces (4) à semiconducteur par de la matière plastique, et
- individualisation des modules (1) de carte à puce dans lequel
- l'application de la bande métallique pour l'autre plan (6) de raccordement et sa structuration en des points de raccordement individuels, s'effectue avant l'application et la structuration du premier plan (3) de contact et
- la structuration de l'autre plan (6) de raccordement, s'effectue conjointement avec la structuration de la bande support de module.

2. Procédé suivant la revendication 1, **caractérisé en ce qu'**il comprend en outre au moins l'un des stades suivants :
- revêtement galvanique du premier plan (3) de contact et/ou de l'autre plan (6) de raccordement,
- mise en place d'une bague (8) d'appui sur l'autre plan (6) de raccordement.

3. Procédé suivant la revendication 1 ou 2, **caractérisé en ce que** l'autre plan (6) de raccordement est en cuivre, et le cuivre est muni d'un revêtement électrolytique en nickel suivi d'un revêtement électrolytique en or.

4. Procédé suivant l'une des revendications 1 à 3, **caractérisé en ce que** la bande métallique est appliquée sensiblement au milieu sur un premier côté de la bande support de module.

5. Procédé suivant l'une des revendications 1 à 4, **caractérisé en ce que** le revêtement par électrolyse du premier plan (3) de contact et de l'autre plan (6) de raccordement s'effectue conjointement.

6. Procédé suivant l'une des revendications 1 à 5, **caractérisé en ce qu'**une bague (8) d'appui est collée sur l'autre plan (6) de raccordement, notamment en utilisant une colle (9) sensible à la pression.

7. Procédé suivant l'une des revendications 1 à 6, **caractérisé en ce que** la structuration de l'autre plan (6) de raccordement s'effectue de manière à former deux points de raccordement, pour la liaison à une antenne (11) notamment à une bobine d'induction pour le transfert de données par induction.

8. Procédé suivant l'une des revendications 1 à 7, **caractérisé en ce que** le premier plan (3) de contact est structuré en surfaces de contact ISO.
